# EUROPÄISCHE PATENTANMELDUNG

(11) **EP 2 073 029 A1**
(43) Veröffentlichungstag der Anmeldung: **24.06.2009**
(21) Anmeldenummer: 08105642.6
(22) Anmeldetag: 23.10.2008
(51) Int. Cl.: G01R 31/36, G01R 31/00, G01R 1/04

(54) **Sensoranordnung für die Zustandserkennung einer Batterie**

(30) Priorität: 18.12.2007 DE 102007060940
(71) Anmelder: Robert Bosch GmbH, 70442 Stuttgart (DE)
(72) Erfinder: Haeffner, Juergen, 71116, Gaertringen (DE); Wetzel, Gabriel, 70825, Korntal-Muenchingen (DE)

(57) **Zusammenfassung**

Die Erfindung betrifft eine Sensoranordnung (4) für die Zustandserkennung einer Batterie (1), die zur Erfassung der elektrischen Zustandsgrößen der Batterie (1) in der Nähe der Polklemmen (2,3) der Batterie (1) angeordnet ist. Zusätzlich zu einer Messstrecke ist auch eine elektronische Schaltung (9) in die Sensoranordnung (4) integriert, deren Versorgungsspannung aus der Batterie (1) direkt entnommen wird, wobei die Versorgungsspannung über eine Sicherung (12) derart mit der elektronischen Schaltung (9) verbunden ist, dass die Sicherung (12) stoffschlüssig in die Zuleitung (5a) der Versorgungsspannung im Gehäuse der Sensoranordnung (4) eingefügt ist.

## Beschreibung

### Stand der Technik

Die Erfindung betrifft eine Sensoranordnung für die Zustandserkennung einer Batterie, insbesondere als Bestandteil eines Energiemanagementsystem in Kraftfahrzeugen, nach der Gattung des Hauptanspruchs.

Um den Batteriezustand in einem Kraftfahrzeug zu ermitteln, kommen in der Regel an sich bekannte Batteriesensoren oder auch entsprechende elektronische Schaltungen in Batteriemanagementsystemen zum Einsatz.

Es ist beispielsweise aus der DE 10 2005 039 587 A1 bekannt, dass eine Erfassung des Zustands einer Batterie im Bordnetz eines Kraftfahrzeuges mit einer Batteriesensoreinheit durchgeführt wird. Diese Batteriesensoreinheit als Messstrecke mit einem Shuntwiderstand wird direkt an eine Polklemme der Batterie angeklemmt und kombiniert praktisch die Messstrecke mit der mechanischen Anschlusseinheit.

Weiterhin ist in der DE 10 2006 013 911 A1 beschrieben, dass ein Kommunikationsweg zwischen der Erfassung der Messwerte zur Prüfung elektrischer Verbraucher im Kraftfahrzeug und der Bewertung dieser daraus gewonnenen Daten über einen CAN- oder LIN-Bussystem einer Rechnereinheit zur Verfügung gestellt wird.

### Offenbarung der Erfindung

Die Erfindung geht von einer Sensoranordnung für die Zustandserkennung einer Batterie aus, die zur Erfassung der elektrischen Zustandsgrößen der Batterie in der Nähe der Polklemmen der Batterie angeordnet ist. Die Zustandsgrößen sind dabei in der Regel der Strom, die Spannung und gegebenenfalls auch die Temperatur der Batterie. Um auf einfache Weise zusätzlich zu einer Messstrecke auch eine elektronische Schaltung in die Sensoranordnung zu integrieren, deren Versorgungsspannung aus der Batterie direkt entnommen wird, ist die Versorgungsspannung erfindungsgemäß in vorteilhafter Weise über eine Sicherung derart mit der elektronischen Schaltung verbunden, dass die Sicherung stoffschlüssig in die Zuleitung der Versorgungsspannung im Gehäuse der Sensoranordnung eingefügt ist.

Die Sicherung kann dabei ein in die Leitungsführung eingelötetes Miniatur-Schmelz- oder Schaltsicherungselement, zum Beispiel eine sogenannte 0603 Standardbaugröße für kleine Komponenten sein. Alternativ kann die Sicherung auch durch eine in die Leitungsführung eingebrachte Schmelzsicherung in Form einer verengten Leiterbahn sein oder mit sonstigen schaltungstechnisch üblichen Mitteln innerhalb der Sensoranordnung realisiert werden.

Gemäß der Erfindung kann eine oder eine Mehrzahl von Batterien in der elektrischen Energieversorgung eines Kraftfahrzeuges angeordnet sein, wobei die eine oder die mehreren Sensoranordnungen zur Zustandserkennung der Batterien mit einem Energiemanagementsystem des Kraftfahrzeuges für einen Datenaustausch kommunizieren. Für die Kommunikation der mindestens einen Sensoranordnung mit dem Energiemanagementsystem ist ein sogenannter in der Kraftfahrzeugtechnik üblicher CAN-Bus oder ein LIN-Bus geeignet.

Die steigende Anzahl elektrischer Verbraucher in Kraftfahrzeugen führt oft zu einer deutlich steigenden Zahl von Ausfällen aufgrund zu stark entladener oder defekter Batterien. Dies macht in der Regel einen Einsatz eines Energiemanagementsystems sinnvoll, das in Verbindung mit einer Batteriezustandserkennung die benötigten Informationen aus den messbaren Batteriegrößen, wie Strom, Spannung und Temperatur, verarbeitet.

Zur Erhöhung der Zuverlässigkeit des Bordnetzes werden Fahrzeug oft mit einer zusätzlichen Batterie ausgestattet, wobei eine Batterie hauptsächlich für den Motorstart verwendet wird. Die zweite Batterie dient dann der Versorgung von sogenannten Komfortverbrauchern sowie als Backup für die Versorgung besonders sicherheitskritischer Verbraucher, wie zum Beispiel elektrohydraulische Bremsen oder sogenannte x-bywire-Systeme. Zur Steuerung des Energieflusses in derartigen Zwei-Batterie-Bordnetzen sind dann Energiemanagementsysteme notwendig, die relativ komplex aufgebaut sind.

Mit diesen sogenannten intelligenten Batteriesensoren können die Batteriegrößen, wie Strom, Spannung und Temperatur mit hoher Genauigkeit und Abtastrate erfasst und je nach Partionierung teilweise oder vollständig die Aufgabe der Batteriezustandserkennung ausgeführt werden. Das übergeordnete Energiemanagementsystem zur Erledigung der verbleibenden Aufgaben kann dann in einem Host-Steuergerät, bzw. das Motorsteuergerät, mit dem Batteriesensor über eine einfache und kostengünstige serielle Schnittstelle, zum Beispiel der sogenannte LIN-Bus, kommunizieren.

Wie in der Beschreibungseinleitung erwähnt, wird, um die hohen Anforderungen insbesondere an die Spannungsmessung zu erfüllen, die Spannnungs-Messleitung so nah wie möglich an dem Pluspol der Batterie abgezweigt. Da erfindungsgemäß die Spannnungs-Messleitung auch als Versorgungsleitung verwendet wird, darf ein Spannungsabfall auf dieser Leitung nicht die Genauigkeit der Messung beeinflussen, da hiervon auch die Genauigkeit der Zustandserkennung der Batterie abhängt. Es wird andererseits verlangt, dass eine solche Versorgungsleitung über eine Sicherung abgesichert ist, wobei es insbesondere bei einem Kraftfahrzeug schwierig ist, solche Sicherung auf einer losen Leitung zu montieren. Daher werden in der Regel beim Stand der Technik alle Sicherungen in einer Box, meistens weit von der Batterie entfernt, z. B. unter dem Dashboard, links unten dem Lenkrad, angeordnet. Allerdings wird nur ein Teil des Stroms bis zu dieser Sicherungsbox geführt; der Rest, z. B. für den Starter oder vom Generator, fließt nicht über die Sicherungsbox. Andererseits besteht auch dann, wenn der ganze Strom bis zu der Sicherungsbox geführt würde, das Problem der Genauigkeit aufgrund des Spannungsabfalls entlang der Leitung zwischen Batterie-Pluspol und der Sicherungsbox.

Durch die erfindungsgemäß stoffschlüssig im Gehäuse der Sensoranordnung eingebrachte Sicherung ist somit in vorteilhafter Weise erreicht, dass auch die üblichen Kontaktprobleme der Stecksicherung in der Sicherungsbox oder auf einer Leitung vermieden sind. Da der Stromverbrauch einer solchen erfindungsgemäßen Sensoranordnung sehr niedrig ist, ist dieser Strom in der Regel zu gering, um eine um eine Korrosion der Sicherungsanschlussstelle und damit störende Übergangswiderstände zu vermeiden.

### Kurze Beschreibung der Zeichnung

Die Erfindung wird nachfolgend anhand des in der Figur der Zeichnung gezeigten Ausführungsbeispiels erläutert. Dabei zeigt:

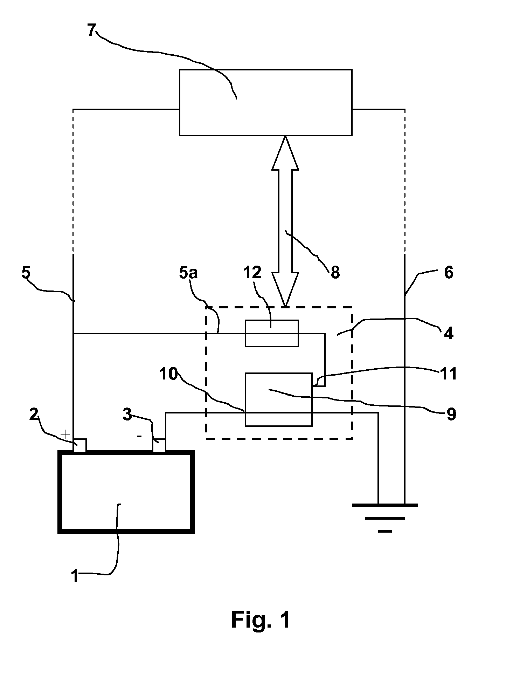

Figur 1 eine schematisches Blockschaltbild einer Anordnung einer Sensoranordnung im Bereich der Batterie eines Kraftfahrzeuges.

### Ausführungsform der Erfindung

In Figur 1 ist eine Batterie 1 für ein Kraftfahrzeug gezeigt, deren Zustand durch Messung elektrischer Größen, insbesondere Strom und Spannung, möglichst nahe an den Polklemmen 2 (+) und 3 (-) der Batterie 1 mit einer Sensoranordnung 4 als Batteriesensor erfasst werden soll. Die mechanische Anordnung direkt an der Polklemme 2 (+) zur Messung von Strom und/oder Spannung ist beispielsweise im eingangs erwähnten Stand der Technik DE 10 2005 039 587 A1 ausführlich beschrieben und wird daher hier nicht näher erläutert.

Die an die Batterie 1 angeschlossenen Verbraucher sind dann hinter der anschließend gestrichelt dargestellten Führung der Leitung 5 (+) und der Masseleitung 6 (+) angeordnet. Hier ist schematisch ein Energiemanagementsystem 7 angedeutet, dass über eine Busleitung 8, zum Beispiel ein LIN-Bus, mit der Sensoranordnung 4 kommuniziert.

In der Sensoranordnung 4 befindet sich eine elektronische Schaltung 9 mit der teilweise eine Auswertung oder Vorverarbeitung der auf der Messstrecke im Bereich der Schaltung 9 erfassten elektrischen Größen durchführbar ist. Die Versorgungsspannung wird hier direkt an Anschlüsse 10 und 11 der elektronischen Schaltung 9 angeschaltet und wird dazu über die Leitung 5a als Plusleitung über eine im Gehäuse der Sensoranordnung 4 eingelötete Miniatursicherung 12 direkt ohne weitere Kontaktstellen aus der Batterie 1 entnommen. Alternativ kann die Sicherung 12 auch durch eine in die Leitungsführung der elektronischen Schaltung 9 eingebrachte Schmelzsicherung in Form einer verengten Leiterbahn realisiert sein. Durch die stoffschlüssig, eventuell auch durch eine stoffschlüssig eingebrachte Stecksicherung, im Gehäuse der Sensoranordnung 4 eingebrachte Sicherung 12 sind somit Kontaktprobleme an der Sicherung12 vermieden.

## Patentansprüche

1. Sensoranordnung für die Zustandserkennung einer Batterie (1), die zur Erfassung der elektrischen Zustandsgrößen der Batterie (1) in der Nähe der Polklemmen (2,3) der Batterie (1) angeordnet ist, **dadurch gekennzeichnet, dass** zusätzlich zu einer Messstrecke auch eine elektronische Schaltung (9) in die Sensoranordnung (4) integriert ist, deren Versorgungsspannung aus der Batterie (1) direkt entnommen wird und dass die Versorgungsspannung über eine Sicherung (12) derart mit der elektronischen Schaltung (9) verbunden ist, dass die Sicherung (12) stoffschlüssig in die Zuleitung (5a) der Versorgungsspannung im Gehäuse der Sensoranordnung (4) eingefügt ist.

2. Sensoranorndung nach Anspruch 1, **dadurch gekennzeichnet, dass** die Sicherung (12) ein in die Leitungsführung eingelötetes Miniatur-Schmelz- oder Schaltsicherungselement ist.

3. Sensoranordnung nach Anspruch 1, **dadurch gekennzeichnet, dass** die Sicherung (12) eine in die Leitungsführung eingebrachte Schmelzsicherung in Form einer verengten Leiterbahn ist.

4. Sensoranordnung nach Anspruch 1, **dadurch gekennzeichnet, dass** die Sicherung (12) durch in die Leitungsführung eingebrachte Halbleiter-Schaltbauelemente realisiert ist.

5. Sensoranordnung nach einem der vorhergehenden Ansprüche, **dadurch gekennzeichnet, dass** die Zustandsgrößen Strom, Spannung und Temperatur der Batterie (1) sind.

6. Sensoranordnung nach einem der vorhergehenden Ansprüche, **dadurch gekennzeichnet, dass** eine oder eine Mehrzahl von Batterien (1) in der elektrischen Energieversorgung eines Kraftfahrzeuges angeordnet sind und die eine oder die mehreren Sensoranordnungen (4) zur Zustandserkennung der Batterien (1) mit einem Energiemanagementsystem (7) des Kraftfahrzeuges für einen Datenaustausch kommunizieren.

7. Sensoranordnung nach Anspruch 6, **dadurch gekennzeichnet, dass** für die Kommunikation der mindestens einen Sensoranordnung (4) mit dem Energiemanagementsystem (7) über eine Busleitung (8), vorzugsweise einen CAN-Bus oder einen LIN-Bus, erfolgt.
